**Europäisches Patentamt**

(19) **European Patent Office**

**Office européen des brevets**

(11) Veröffentlichungsnummer: **0 162 934**
**B1**

(12) EUROPÄISCHE PATENTSCHRIFT

(45) Veröffentlichungstag der Patentschrift:
08.11.89

(51) Int. Cl.⁴: **G 11 C 5/02,** G 11 C 8/00,
G 11 C 7/00

(21) Anmeldenummer: 84105426.5

(22) Anmeldetag: 14.05.84

(54) Halbleiterspeicher.

(43) Veröffentlichungstag der Anmeldung:
04.12.85 Patentblatt 85/49

(45) Bekanntmachung des Hinweises auf die Patenterteilung:
08.11.89 Patentblatt 89/45

(84) Benannte Vertragsstaaten:
AT DE FR GB IT

(56) Entgegenhaltungen:
DE-A- 3 326 943
DE-A- 3 337 850
US-A- 4 266 283

PATENTS ABSTRACTS OF JAPAN, Band 4, Nr. 172
(P-38)[654], 27. November 1980; & JP - A - 55 117 786
PATENTS ABSTRACTS OF JAPAN, Band 5, Nr. 52
(P-56)[724], 11. April 1981; & JP - A - 56 7288
IBM TECHNICAL DISCLOSURE BULLETIN, Band 13, Nr.
7, Dezember 1970, Seiten 1927-1928, New York, US; N.F.
BRICKMAN: "Large scale integration"
ELECTRICAL DESIGN NEWS, Band 17, Nr. 10, 15. Mai
1972, Seiten 60-61, Denver, US; D. PEARSON: "How to
tailor your memory needs with a minimum of external
parts"
IEEE International Solid-State Circuits Conference,
February 1980, New York, US; WIEDMANN et al.:"A
16Kb Static MTL/I2L Memory Chip", Seiten 222, 223 und
276

(73) Patentinhaber: **IBM DEUTSCHLAND GMBH,**
**Pascalstrasse 100, D-7000 Stuttgart 80 (DE)**

(84) Benannte Vertragsstaaten: **DE**

(73) Patentinhaber: **International Business Machines**
**Corporation, Old Orchard Road, Armonk,**
**N.Y. 10504 (US)**

(84) Benannte Vertragsstaaten: **FR GB IT AT**

(72) Erfinder: **Wiedmann, Siegfried, Dr. Dipl.-Ing., Im**
**Himmel 64A, D-7000 Stuttgart 80 (DE)**

(74) Vertreter: **Rudolph, Wolfgang, Dipl.-Ing., IBM**
**Deutschland GmbH Schönaicher Strasse 220,**
**D-7030 Böblingen (DE)**

## Beschreibung

Die Erfindung betrifft einen Halbleiterspeicher nach dem Oberbegriff des Patentanspruchs 1.

Es ist bei Speichern mit bipolaren Transistoren und mit Feldeffekttransistoren üblich, die Zeilen- oder Wortleitungen in zwei Abschnitte aufzuteilen. Ein solcher Speicher ist zum Beispiel in der DE-OS 25 48 564 beschrieben. Dieser Speicher ist dadurch gekennzeichnet, daß die Zeilenleitungen jeweils rechte und linke Zeilenleitungsabschnitte aufweisen, daß eine der Zahl der Zeilenleitungen entsprechende Anzahl von Abtastverstärkern in einer Spalte derart angeordnet ist, daß jeder der Verstärker einen rechten Zeilenleitungsabschnitt mit einem linken Zeilenleitungsabschnitt verbindet, daß die Speicherzellen jeweils einen Feldeffekttransistor, dessen Gate an einer der Spaltenleitungen und dessen Source- oder Drain-Anschluß an einer der Zeilenleitungen angeschaltet sind, und ein kapazitives Speicherelement aufweisen, daß ferner mehrere Hilfszellen vorgesehen sind, von denen jeweils eine mit einem der rechten oder linken Zeilenleitungsabschnitte verbunden ist, und daß eine Eingangs-/Ausgangs-Sammelleitung an einem Ende der Zeilenleitungen angeordnet ist und mit diesem verbunden ist, wobei die Sammelleitung mit einigen der Speicherzellen für die Abtastverstärker koppelbar ist. Dadurch, daß die Wortschaltkreise in der Mitte zwischen der linken und der rechten Wortleitung angeordnet sind, wird die effektive Wortleitungskapazität halbiert. Trotzdem ist insbesondere für Speicher mit einer sehr großen Anzahl von Speicherzellen pro Wortleitung diese Wortleitungskapazität noch zu hoch, so daß sich ein derartiger Vorschlag für höchstintegrierte Speicher mit sehr hoher Informationsspeicherkapazität nicht eignet. Das Festlegen der Schaltkreise in der Mitte eines Chips bedeutet zu starre Forderungen für das Design. Darüber hinaus können die Wortleitungen erst nach dem Entladen selektiert werden, so daß ein Geschwindigkeitsverlust auftritt. Außerdem sind große kapazitive Ströme vorhanden, die eine erhöhte Verlustleistung und Störprobleme innerhalb der Speichermatrix hervorrufen.

Außerdem ist in der Section X 53: 256 K/1 MB DRAMS-II, auf der IEEE International Solid-State Circuits Conference 1984, veröffentlicht im Digest of Technical Papers, Seiten 274, 275 und 353, ein 256 K NMOS DRAM veröffentlicht worden, das in mehrere Teilmatrizen bzw. Subarrays aufgeteilt ist. Um eine gewünschte Geschwindigkeit sowohl beim Lesen als auch beim Schreiben zu erreichen, wurde auf dem Chip eine Speicherhierarchie derart aufgebaut, daß auf den Chip in der Mitte Pufferspeicher zwischen den einzelnen Subarrays angeordnet sind. Über diese Pufferspeicher wird gelesen bzw. geschrieben. Obwohl hier Pufferspeicher zur Erhöhung der Operationsgeschwindigkeit erforderlich sind, weist dieser Speicher trotz alledem eine relativ niedrige Schreib-/Lesegeschwindigkeit auf und eignet sich außerdem für noch größere Speicher, die mit sehr kleinen Strömen arbeiten müssen, wie zum Beispiel solche mit MTL-Zellen, überhaupt nicht. Die Chipfläche für den eigentlichen Speicher wird durch die Puffer und Treiberschaltkreise beschränkt.

Um die Speicherkapazität eines Speichers auf das Doppelte zu erhöhen, wurde außerdem in der europäischen Anmeldung 81 109 372 (EP-A-00 78 338) eine Lösung für einen Feldeffekttransistorspeicher bekannt, bei dem die Ausgänge der Abfühlverriegelungsschaltungen mit zwei Paaren kreuzgekoppelter Ladungsspeicherelemente als Bitleitungs-Koppeltransistoren verbunden sind, und bei dem mit den Ladungskoppelelementen um das Doppelte erweiterte Bitleitungspaare verbunden sind. Außerdem ist eine zusätzliche Bitleitung zur Ansteuerung der zusätzlichen Speicherzellen in getrennten Abschnitten angeordnet, wobei jeder Abschnitt seine eigenen Referenzzellen aufweist und mit der Abfühlverriegelungsschaltung über als kapazitätsarme Leitungen ausgebildete Schichten und Ladungskopplungselemente verbunden ist. Obwohl hier unter Verwendung einer zweiten Metallisierungsschicht für die Verdrahtung und der Selbstisolierungscharakteristiken der als Leseverstärker dienenden FET-Verriegelungsschaltungen eine Verdopplung der Anzahl der Bits pro Bitleitung erreicht wird, ohne daß die Zellgröße erhöht werden muß und ohne daß sich das Lesesignal unzulässig soweit verkleinert, daß ein größerer Aufwand in den Peripherieschaltkreisen erforderlich ist, ist eine Erweiterung der Bitwortleitungen und der damit spezifisch in Verbindung stehenden Probleme weder gezeigt noch angedeutet, so daß sich auch diese Lösung nicht für Speicher mit sehr hoher Speicherkapazität in Höchstintegrationstechnik eignet.

Ein Speicher, der eine sehr hohe Speicherkapazität und äußerst kurze Zugriffszeit bei kleinster Verlustleistung und höchster Integrationsdichte aufweist, ist in der europäischen Patentanmeldung 83 105 171.9 (EP-A-0 126 784), die unter Artikel 54(3) des EPÜ fällt, beschrieben. Dieser Halbleiterspeicher besitzt Wortleitungen, die in mehrere Teilwortleitungen oder Abschnitte aufgeteilt sind. Jede Teilwortleitung ist mit einem Wortschalter verbunden, und alle Wortschalter einer Wortleitung sind über eine erste Wortansteuerleitung und eine zweite Wortansteuerleitung selektierbar und steuerbar. Obwohl hierdurch ein Schaltungskonzept vorgeschlagen ist, das die oben beschriebenen Nachteile vermeidet und durch Aufteilung der Wortleitungen in mehrere Teilwortleitungen und die Einfügung von separat ansteuerbaren Wortschaltungen für jede Teilwortleitung die effektiv wirksame Wortleitungskapazität auf 1/N der gesamten effektiven Wortleitungskapazität ohne Unterteilung vermindert wurde, ist eine Weiterverbesserung dieses Konzepts erforderlich, wenn, wie bei Speicherchips mit extrem hoher Speicherkapazität gefordert, die Integrationsdichte, die Zugriffszeit und die Verlustleistung weiter wesentlich verbessert werden sollen.

Ein Halbleiterspeicher nach dem Oberbegriff des Patentanspruchs 1 ist aus der DE-A-33 37 850 bekannt. Der Erfindung liegt deshalb die Aufgabe zugrunde, einen VLSI-Halbleiterspeicher mit statischen oder dynamischen Speicherzellen, der in eine Anzahl Untermatrizen oder Subarrays aufgeteilt ist und bei dem die Wortleitungen in mehrere Teilwortleitungen oder Abschnitte aufgeteilt sind, wobei jede Teilwortleitung mit einem Wortschalter verbunden ist, der über Wortansteuerleitungen selektier- und steuerbar ist, dahingehend zu verbessern, daß trotz wesentlicher Erhöhung der Speicherdichte, der Speicherkapazität und der Geschwindigkeit die Gesamtverlustleistung signifikant verringert werden kann.

Die Lösung der Aufgabe besteht im Kennzeichen des Patentanspruchs 1.

Weitere Ausgestaltungen der Lösung sind in den Kennzeichen der Unteransprüche charakterisiert.

Obwohl sich normalerweise die Verlustleistung bei zunehmender Integrationsdichte und Speicherkapazität auf einem Chip und signifikanter Erhöhung der Lese- und Schreibgeschwindigkeit im Pikosekundenbereich sowie im echten Nanosekundengebiet bei den bekannten Speicherschemen und -strukturen wesentlich erhöht, wurde hier erstmals eine Lösung gefunden, die diesen bisher bekannten Trend umkehrt. Insbesondere für Speicherchips mit einer Kapazität im Megabitbereich weist die vorgeschlagene Lösung erstmals in eine Richtung, die Speicher auf einem Chip mit einer derartigen großen Speicherkapazität bei kleinster Zugriffszeit und Verlustleistung praktisch ermöglicht. Durch die Aufteilung der Speichermatrix auf dem Chip in viele Subarrays bzw. Teilmatrizen, wobei die Anzahl der Speicherzellen an einer Wortleitung eines Subarrays der Zahl der Datenbits entspricht, werden erstmals lediglich die Wort- und Bitleitungen nur des selektierten Subarrays angesteuert, so daß nur ein Bruchteil der kapazitiven Umladungen gegenüber der bisher bekannten Schemata bewerkstelligt werden muß. Dadurch sind wesentlich kleinere Treiberströme und Verlustleistungen erforderlich. Hinzu kommt, daß durch die Art der Verknüpfung der Bitleitungen aller Subarrays über die Lese- und Schreibschalter keinerlei Mehraufwand an Schaltelementen gegenüber den bisher bekanntgewordenen Anordnungen erforderlich ist. Man erzielt die gleichen Vorteile der Treiberstromersparnis wie bei einer Aufteilung des Gesamtspeichers in mehrere komplette Teilspeicher, ohne einen Mehraufwand an Peripherieschaltkreisen, der bei einer solchen Lösung unbedingt erforderlich wäre, in Kauf nehmen zu müssen. Durch die Entkopplung der Bitleitungen von nichtselektierten Subarrays mit Hilfe der Lese- und Schreibschalter wird nun auch die effektive Bitleitungskapazität um den Faktor N reduziert, so daß für typische Zahlen von N = 8, 16, 32 die Verlustleistung um mehr als eine Größenordnung reduziert werden kann.

Die Erfindung wird anhand eines in den Zeichnungen dargestellten Ausführungsbeispiels näher beschrieben. In der Zeichnung bedeuten:

Fig. 1 ein detailliertes Gesamtschaltbild eines in mehrere Subarrays unterteilten Speichers auf einem Chip;

Fig. 2 ein vereinfachtes Blockdiagramm, anhand dessen die große Variabilität der Anordnung der Dateneingangs- und Datenausgangsschaltungen gezeigt wird;

Fig. 3 eine Ausführung eines auf einem Chip befindlichen Speichers mit Subarrays, bei dem die Lese- und Schreibsammelleitungen zusammengefaßt sind und

Fig. 4 eine maßstäbliche Darstellung eines Speicherchips mit 16 Subarrays, den dazugehörigen Decodern und Peripherieschaltkreisen.

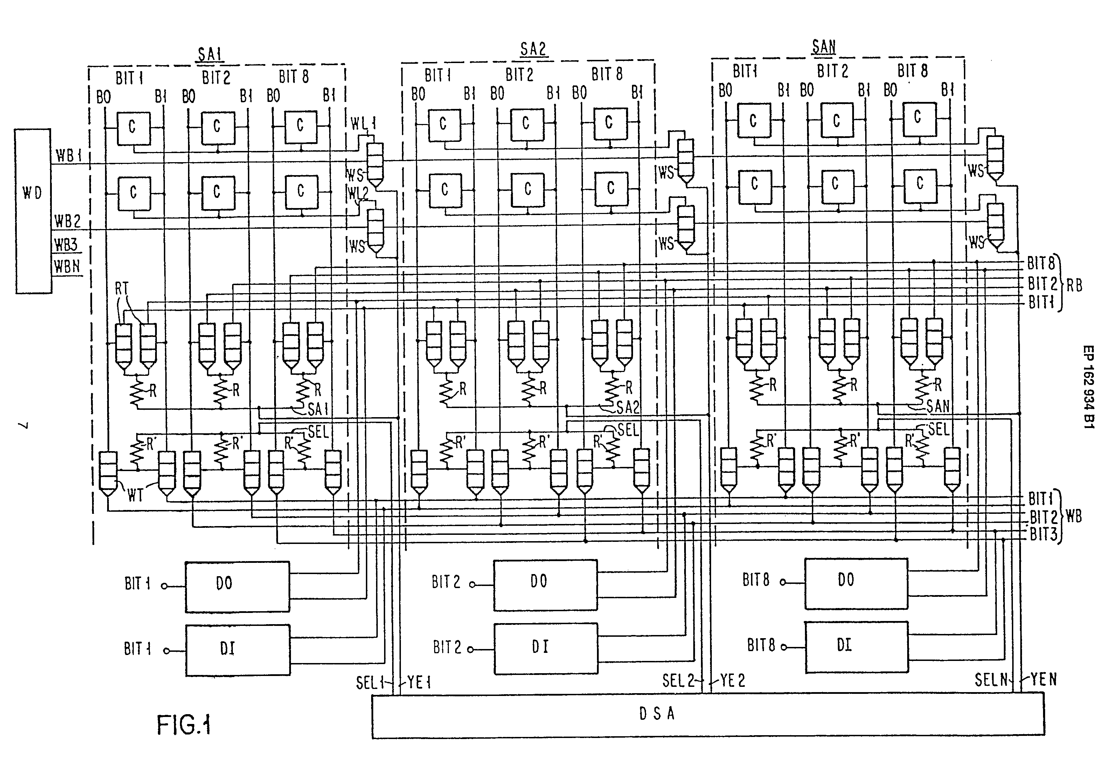

Der in Fig. 1 dargestellte Speicher befindet sich auf einem einzigen Halbleiterchip. Der Speicher ist in mehrere Subarrays SA 1 bis SA N aufgeteilt. Die Zahl der Bitleitungspaare B0, B1 eines Subarrays entspricht hier der Anzahl der externen Dateneingänge und Datenausgänge. Die Zahl der Bitleitungspaare eines Subarrays kann auch einem ganzzahligen Vielfachen der Zahl der externen Datenein- und -ausgänge entsprechen. Der Wortdecoder WD, der an seinen Eingängen die Wortadressen empfängt, gibt seine Ausgangssignale nicht direkt auf die Wortleitungen, sondern auf die Wortansteuerleitungen WB 1 bis WB N in der X-Koordinate. Diese Wortansteuerleitungen führen auf die Basis der zwischen den einzelnen Subarrays SA 1 bis SA N angeordneten Wortleitungssteuerschalter WS. Das heißt mit anderen Worten, daß die Wortleitungen WL für die einzelnen Subarrays jeweils an einer Schnittstelle unterbrochen sind und mit einem Wortleitungssteuerschalter WS selektiv zu- und abgeschaltet werden können. Außerdem gehört zu jedem Subarray SA 1 bis SA N eine in der Y-Koordinate verlaufende Ansteuerleitung YE 1 bis YE N, die mit den Emittern der Wortleitungssteuerschalter verbunden ist. Die Wortleitungen WL eines jeden Subarrays SA 1 bis SA N sind jeweils mit dem Kollektor eines Wortleitungssteuerschalters WS verbunden. Besonders zu bemerken ist, daß die in der X-Koordinate verlaufende Wortansteuerleitung WB jeweils gemeinsam für alle Subarrays SA 1 bis SA N vorhanden ist. Beim Betrieb des Speicherchips wird jeweils nur eine Wortleitung WL eines Subarrays SA 1 bis SA N selektiert. Zum Beispiel wird die Wortleitung WL 1 im Subarray SA 1 durch einen negativen Ansteuerimpuls über ein Ansteuersignal YE 1 vom Decoder DSA für die Subarray SA 1 und einen positiven Ansteuerimpuls über die Wortansteuerleitung WB 1 vom Wortdecoder WD selektiert. Dadurch werden die Zellen für die Bits 1 bis 8, die mit der Wortleitung WL 1 verbunden sind, gleichzeitig adressiert. An jedem Bitleitungspaar B0, B1 ist ein Paar Lesetransistoren RT angeschlossen, die sowohl als Vorverstärker als auch als Entkopplungselemente für die gemeinsamen Lesesammelleitungen RB der Bits 1 bis 8 dienen. Die Emitter der Lesetransistoren RT sind paarweise über einen Widerstand R innerhalb eines jeden Subarrays SA 1 bis SA N mit einer gemeinsamen Selektionsleitung SA 1 bis SA N für die Subarrays verbunden, die ihrerseits mit der in Y-Richtung verlaufenden Steuerleitung vom Decoder DSA für die Subarrays verbunden werden kann.

Die als Ausgänge dienenden Kollektoren der Lesetransistoren RT von Bit 1 des Subarrays SA 1 sind mit den ebenfalls als Ausgänge dienenden Kollektoren der Bit-1-Lesetransistoren RT aller weiteren auf dem Chip befindlichen Subarrays SA 2 bis SA N über ein gemeinsames Sammelleitungspaar RB für Bit 1 verbunden. An die Bitleitungspaare B0, B1 sind außer den Lesetransistoren RT die Schreibschaltertransistoren WT angeschlossen, die über die Schreibsignal-Sammelleitung WB für die Bits 1 bis 8 und durch eine gemeinsame Schreibselektleitung SEL 1 bis SEL N für das jeweilige Subarray SA 1 bis Sa N vom Decoder DSA für die Subarrays gesteuert werden. Die einzuschreibenden Zellinformationen 0 oder 1 werden über die entsprechenden Schreibsignal-Sammelleitungen WB für die Bits 1 bis 8 zugeführt, die mit den Emittern der jeweiligen Schreibschalter WT der einzelnen Subarrays SA 1 bis SA N verbunden sind. Die vom Decoder DSA für die Subarrays in Y-Richtung verlaufenden Selektionsleitungen SEL 1 bis SEL N sind über die gemeinsame Leitung SEL in einem jeden Subarray SA 1 bis SA N über Widerstände R' mit den Basen der Schreibtransistorenpaare WT verbunden. Beim Betrieb wird durch das Aktivieren des jeweiligen Schreibschaltertransistors WT über die Leitungen SEL und SEL 1 bis SEL N die Schreibinformation der Datenleitungen WB auf die entsprechende Bitleitung B0 oder B1 des dazugehörigen Datenbits 1 bis 8 übertragen, das heisst in die jeweils selektierte Zelle wird entweder eine Null oder eine Eins eingeschrieben.

Die Leitungen für die Bits 1 bis 8 der Lesesammelleitung RB werden an geeigneter Stelle auf dem Chip angezapft und mit einem Datenausgangs-Schaltkreis DO für jedes Bit 1 bis 8 verbunden. Da im allgemeinen relativ wenige externe Datenausgänge verwendet werden, kann für einen Datenausgangs-Schaltkreis DO ein relativ aufwendiger Zwischen- und Endverstärker benutzt werden, so daß trotz einer relativ großen kapazitiven Last der Lesesammelleitung RB die Information der selektierten Speicherzelle C sehr schnell zum externen Datenausgang gelangt. Auf die Gesamtfläche des Speicherchips bezogen ist der Aufwand für die Datenausgangs-Schaltkreise DO selbst bei großem Schaltelementeaufwand vernachlässigbar klein.

Ebenso werden die Leitungen für die Bits 1 bis 8 der Schreibsammelleitung WB an geeigneter Stelle angezapft, um mit dem entsprechenden Dateneingangs-Schaltkreis DI für die Bits 1 bis 8 verbunden zu werden. Auch der Dateneingangs-Schaltkreis kann als relativ aufwendiger Schaltkreis aufgebaut werden, damit die Schreibleitungen schnell geschaltet werden können, und zwar trotz einer relativ hohen Kapazität der Schreibsammelleitung WB.

Es soll hier noch einmal darauf hingewiesen werden, daß die Leseleitungen und die Schreibleitungen für jedes Bit 1 bis 8 der Lesesammelleitung RB und der Schreibsammelleitung WB für alle Subarrays SA 1 bis SA N gemeinsam sind, das heisst die Leseleitungen, zum Beispiel von Bit 1, werden über die Leseschalter RT jeweils mit dem Bitleitungspaar B0, B1 von Bit 1 aus jedem Subarray SA 1 bis SA N direkt logisch verknüpft. In analoger Weise gilt dies auch für die Schreibleitungen. Bei einer Lese- oder Schreiboperation werden lediglich die Wort- und Bitleitungen des selektierten Subarrays angesteuert, so daß nur ein Bruchteil der kapazitiven Umladung gegenüber bei bisher bekanntgewordenen Speichern verarbeitet werden muß. Dadurch sind wesentlich kleinere Treiberströme und Verlustleistungen erforderlich. Durch diese Art der Verknüpfung der Bitleitungen aller Subarrays über die Lese- und Schreibschalter RT und WT ist keinerlei Mehraufwand an Schaltelementen gegenüber den bisher bekanntgewordenen Speicherorganisationen erforderlich. Man erzielt die gleichen Vorteile der Treiberstromersparnis wie bei einer Aufteilung des Gesamtspeichers in mehrere kleine Speicher, ohne einen Mehraufwand an Peripherieschaltkreisen für jeden Teilspeicher in Kauf nehmen zu müssen. Durch die Entkopplung der Bitleitungen von nicht selektierten Subarrays mit Hilfe der Lese- und Schreibschalter wird die effektive Bitleitungskapazität um den Faktor N reduziert, so daß für typische Zahlen von N = 8, 16, 32 die Verlustleistung um mehr als eine Größenordnung reduziert werden kann. Das Lese- und Schreib-Sammelleitungssystem benötigt eine äußerst kleine Fläche, da auf diesen Leitungen nur mit sehr kleinen Strömen gearbeitet wird und der Aufwand in den Peripherieschaltkreisen zur sicheren Arbeitsweise ohne signifikanten Platzbedarf erhöht werden kann.

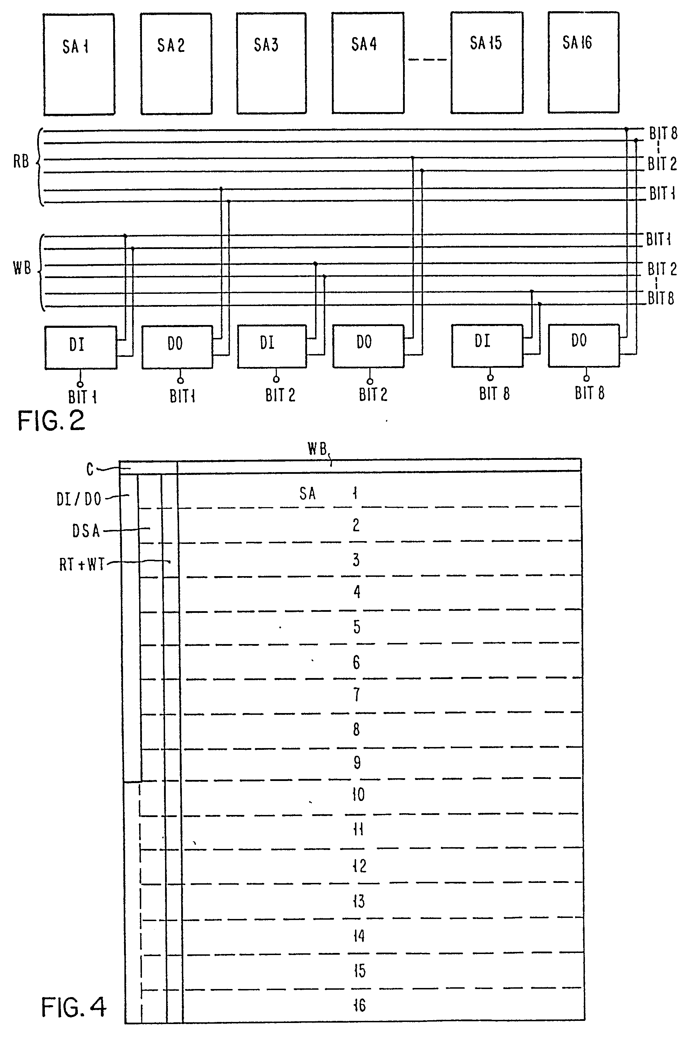

In Fig. 2 ist ein sehr vereinfachtes Prinzipschaltbild mit den Subarrays SA 1 bis 16 dargestellt, die zusammen einen Speicher auf einem Chip bilden. Bei diesem vereinfachten Blockdiagramm nach Fig. 2 sind die Lese-, die Schreibschalter und die Bitleitungspaare weggelassen, um die hohe Variabilität des erfindungsgemäßen Prinzips besser zeigen zu können. Unter den einzelnen Subarrays SA 1 bis SA 16 verlaufen die Lesesammelleitungen RB und die Schreibsammelleitungen WB für die Bits 1 bis 8. Die Dateneingangs-Schaltkreise DI für die Bits 1 bis 8 und die Datenausgangs-Schaltkreise DO für die Bits 1 bis 8 sind in diesem Beispiel als getrennte Schaltkreise mit den jeweiligen Lesesammelleitungen RB bzw. Schreibsammelleitungen WB verbunden. Wie aus Fig. 2 hervorgeht, können diese Dateneingangs- und Datenausgangsschaltungen DI und DO sehr variabel auf dem Chip angeordnet werden. Die Teilung muß auch nicht ein Vielfaches der Teilung für die Subarrays SA 1 bis SA 16 sein. Dadurch können zum Beispiel singuläre Peripherieschaltkreise wie Hilfsspannungsquellen, Referenzschaltungen, Taktschaltkreise optimal zwischen den Datenschaltkreisen auf dem Chip angeordnet werden. Ein sehr wesentlicher Vorteil besteht darin, daß durch die vorgeschlagene Organisation des Speicherchips ein weitgehend modularer Aufbau möglich ist. Dies ist zum Beispiel sehr vorteilhaft, wenn verschieden große Speicherarrays, sog. eingebettete Speicherarrays, verwirklicht werden sollen. Durch diesen modularen Aufbau kann man mit demselben Schaltkreisentwurf und mit dem gleichen physikalischen Layout stark unterschiedliche Speichergrößen realisieren (zum Beispiel $512 \times 8$, $2 K \times 8$, $8 K \times 8$, $512 \times 16$ usw.).

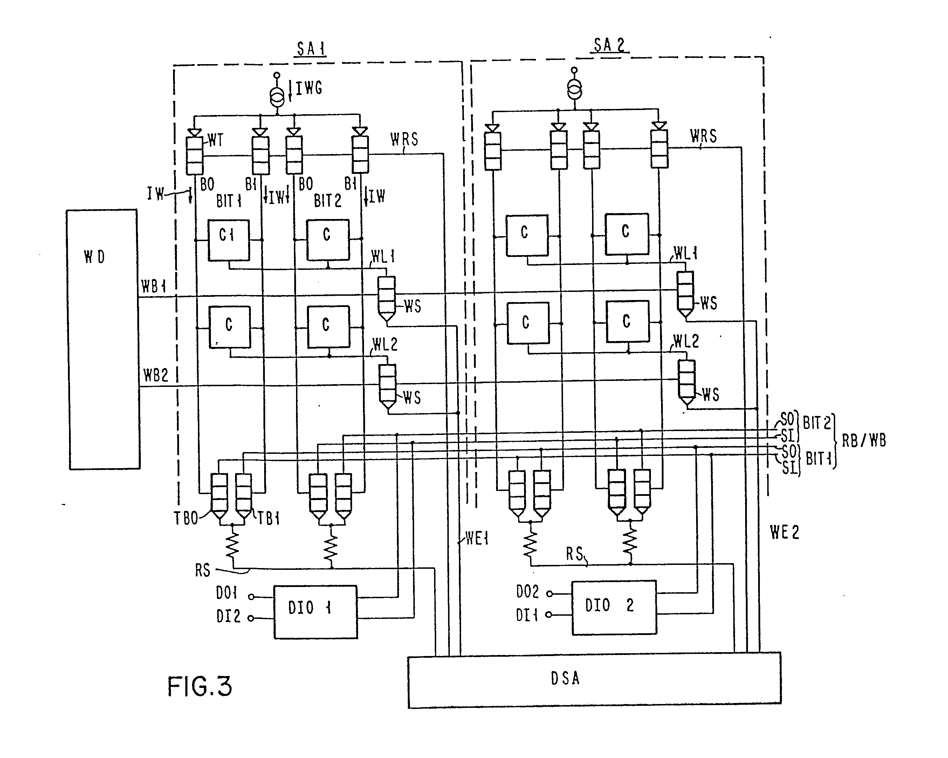

In Fig. 3 ist eine weitere Ausführung eines Speichers auf einem Chip gezeigt, der aus mehreren über Wortleitungsschalter getrennten Subarrays SA 1 bis SA N besteht, wobei hier nur die ersten beiden Subarrays SA 1 und SA 2 dargestellt sind. Angesteuert werden diese Subarrays wiederum über den Wortdecoder WD, an dem die Wortadressen anliegen, und über den Decoder für die Subarrays DSA, an dem ebenfalls die entsprechenden Adressen anliegen. Die Decoder sind wiederum über die in X-Richtung verlaufenden Wortleitungs-Ansteuerleitungen WB 1 bzw. WB 2 mit den entsprechenden Wortschaltern WS in den Subarrays SA 1 bzw. SA 2 verbunden. In Y-Richtung verlaufen vom Decoder DSA für die Subarrays die Wortsteuerleitungen WE 1 und WE 2 sowie die Leseselektionsleitungen RS und die Schreibselektionsleitungen WRS. Bei dieser Ausführung nach Fig. 3 der Schaltungsanordnung sind die Lese- und Schreibsammelleitungen so zusammengefaßt, daß nur noch die Hälfte der Sammelleitungen RB/WB im Vergleich zu Fig. 1 erforderlich ist. Mit Hilfe des Subarray-Decoders DSA wird ein Subarray SA 1 oder SA 2 selektiert, und die Lese- bzw. Schreibelemente werden dadurch aktiviert. Bei einer Leseoperation werden die Lesetransistoren RT des jeweils selektierten Subarrays durch einen negativen Impuls an der Leseselektleitung RS aktiviert, und das Lesesignal der Speicherzellen C einer Wortleitung WL wird auf die Datensammelleitungen S0, S1 übertragen.

Bei einer Schreiboperation werden die Bitleitungsstromquellen IW, die hier von einer gemeinsamen Spannungsquelle IWG gespeist werden, durch einen negativen Schreibselektimpuls auf der Leitung WRS vom Decoder DSA für die Subarrays eingeschaltet. Beim Schreiben einer Null, zum Beispiel in die Zelle C1, fließt der Schreibstrom IW der Bitleitung B0 in die Speicherzelle C1, während der Schreibstrom IW in der Bitleitung B1 durch ein negatives Signal in der Datensammelleitung S1 über die Kollektorbasisdiode oder Schottky-Diode vom NPN-Transistor TB 1 abgeführt wird. Es ist noch anzumerken, daß in dieser Schaltungsanordnung kombinierte Dateneingangs- und -ausgangsschaltungen DIO 1 und 2 für die Datenausgänge DO 1 und DO 2 sowie die Dateneingänge DI 2 und DI 1 angeordnet sind. Außerdem ist zu bemerken, daß im allgemeinen eine Verstärkerfunktion der Schreibschalter nicht notwendig ist, da genügend große Schreibsignale zugeführt werden können.

In Fig. 4 sind die tatsächlichen Größenverhältnisse der einzelnen Komponenten auf einem Chip von einer angenommenen Kantenlänge 5,4 × 6,8 mm gezeigt. Oben am Rand sind links Kontrollschaltkreise C angeordnet, und rechts davon befindet sich der Wortdecoder WD. Senkrecht darunter befinden sich die 16 Subarrays mit jeweils zum Beispiel 512 × 8 Speicherzellen. Zwischen den einzelnen Subarrays befinden sich in der Größenordnung der gestrichelten Linien die Wortleitungsschalter und die Selektionsleitungen vom Decoder DSA für die Subarrays. Im linken senkrecht verlaufenden Feld befinden sich die Dateneingangs- und Datenausgangs-Schaltkreise DI und DO, während sich die Lese-/Schreibschalter RS und WS in diesem Beispiel unmittelbar am Subarray-Decoder DSA befinden. Dieser dargestellte Speicherchip hat somit eine Speicherkapazität von 8 × K 8 Bit, das heisst 64 Kilobit. Ein wesentlicher Grund für die relativ kleine erforderliche Fläche für die Peripherieschaltkreise liegt in der neuen Subarray-Organisation, durch die eine erhebliche Einsparung von Verlustleistung ermöglicht wurde. Bedingt durch die kleinen Ströme kann auch die Fläche für die Sammelleitungen und sonstigen Steuerleitungen und die Fläche für die Peripherieschaltkreise sehr klein gehalten werden, so daß sie in dieser Darstellung nicht in Erscheinung treten.

## Patentansprüche

1. Halbleiterspeicher mit auf einem Chip angeordneten Teilspeichern (Subarrays SA 1 bis SA N) und gemeinsamen Decodier- und Peripherieschaltkreisen (WD, DSA, DO, DI), bei dem die Wortleitungen (WL) in mehrere Teilwortleitungen oder Abschnitte aufgeteilt sind und jede Teilwortleitung mit einem Wortschalter (WS) verbunden ist, wobei ein oder mehrere Wortschalter einer Wortleitung, jedoch nicht alle gleichzeitig, über Ansteuerleitungen (WB, YE) selektiert und gesteuert werden, dadurch gekennzeichnet, daß die Bitleitungspaare (B0, B1) gleicher Wertigkeit (zum Beispiel Bit 1) aller im Halbleiterspeicher vorhandenen Subarrays (SA 1 bis SA N) beim Lesen über Lesetransistoren (RT, TB) und beim Schreiben über Schreibschalter (WT, TB) auf gemeinsame Sammelleitungen (RB und WB oder R/WB) geführt sind, die außerdem mit den für alle Subarrays (SA 1 bis SA N) gemeinsamen Datenein- und Datenausgangs-Schaltkreisen (DI und DO bzw. DIO) direkt verbunden sind, und daß die Lesetransistoren sowohl als Verstärker als auch als Entkopplungselemente für die Bitleitungen und die Sammelleitungen dienen.

2. Halbleiterspeicher nach Anspruch 1, dadurch gekennzeichnet, daß die Bitleitungspaare (B0, B1) über Schreibtransistoren (WT) mit den gemeinsamen Datenschreib-Sammelleitungen (WB) verbunden sind.

3. Halbleiterspeicher nach den Ansprüchen 1 und 2, dadurch gekennzeichnet, daß die Subarrays (SA 1 bis SA N) über Steuerleitungen (YE und SEL 1 bis N) mit den Dekodierschaltkreisen (DSA) für ihre Selektion verbunden sind.

4. Halbleiterspeicher nach den Ansprüchen 1 bis 3, dadurch gekennzeichnet, daß die Bitleitungspaare (B0, B1) gleicher Wertigkeit (zum Beispiel Bit 1) eines jeden Subarrays (SA 1 bis SA N) über Transistoren (TB 0, TB 1) mit einer kombinierten Sammelleitung (RB/WB) zum Lesen und Schreiben verbunden sind, die ihrerseits mit Dateneingangs- und -ausgangsschaltungen (DIO 1 und 2) zum Lesen und Schreiben verbunden sind.

5. Halbleiterspeicher nach Anspruch 1, dadurch gekennzeichnet, daß Schreibtransistoren (WT) eines Subarrays (zum Beispiel SA 1) über eine gemeinsame Stromquelle (IWG) gespeist werden und über eine gemeinsame Steuerleitung (WRS) gesteuert werden, die mit dem Decoder (DSA) für die Subarrays (SA 1 bis SA N) direkt verbunden ist, während die Lesetransistoren (TB 0 bzw. TB 1) innerhalb eines Subarrays (SA 1 bis SA N) über eine andere gemeinsame Steuerleitung (RS) mit dem Decoder (DSA) für die Subarrays verbunden sind.

## Claims

1. Semiconductor memory with partial memories (subarrays SA 1 to SA N) arranged on a chip, and common decoder and peripheral circuits (WD, DSA, DO, DI), where the word lines (WL) are divided into several partial word lines or sectors, and each partial word line is connected with a word switch (WS), with one or several word switches of a word line but not all simultaneously are selected and controlled via word lines (WB, YE), characterized in that the bit line pairs (B0, B1) of the same value (e.g. bit 1) of all subarrays (SA 1 to SA N) in the semiconductor memory are applied for reading via reading transistors (RT, TB) and for writing via writing transistors (WT, TB) to common lines (RB and WB or R/WB) which furthermore are directly connected to the data input and output circuits (DI and DO or DIO) common to all subarrays (SA 1 to SA N), and that the read transistors serve as amplifiers as well as decoupling elements for the bit lines and the common lines.

2. Semiconductor memory as claimed in Claim 1, characterized in that the bit line pairs (B0, B1) are connected via write transistors (WT) with the common data write lines (WB).

3. Semiconductor memory as claimed in Claims 1 and 2, characterized in that the subarrays (SA 1 to SA N) are connected via control lines (YE and SEL 1 to N) to the decoding circuits (DSA) for their selection.

4. Semiconductor memory as claimed in Claims 1 to 3, characterized in that the bit line pairs (B0, B1) of the same value (e.b. bit 1) of each subarray (SA 1 to SA N) are connected via transistors (TB 0, TB 1) to a combined common line (RB/WB) for reading and writing which in turn is connected to data input and output circuits (DIO 1 and 2) for reading and writing.

5. Semiconductor memory as claimed in Claim 1, characterized in that write transistors (WT) of a subarray (e.g. SA 1) are fed via a common current source (IWG) and controlled via a common control line (WRS) that is directly connected to the decoder (DSA) for the subarrays (SA 1 to SA N), whereas the read transistors (TB 0 to TB 1) within a subarray (SA 1 to SA N) are connected via another common control line (RS) to the decoder (DSA) for the subarrays.

### Revendications

1. Mémoire semi-conductrice comportant des mémoires partielles disposées sur une puce (sous-matrices SA 1 à SA N) et des circuits de commutation de décodage et périphériques communs (WD, DSA, D0, D1), dans laquelle les conducteurs de mots (WT) sont subdivisés en plusieurs conducteurs de mots partiels ou sections, et chaque section de conducteur de mots est reliée à un commutateur de mots (WS) un ou plusieurs commutateurs de mots d'un conducteur de mots, mais pas tous en même temps, pouvant être sélectionnée et commandée par l'intermédiaire de conducteurs d'activation (WB, YE), caractérisée en ce que les paires de conducteurs de bits (B0, B1) de même valeur (par exemple bit 1) de toutes les sous-matrices présentes dans une mémoire semi-conductrice (SA 1 à SA N) passent, lors de la lecture par l'intermédiaire de transistors de lecture (RT, TB) et, lors de l'écriture, par l'intermédiaire de commutateurs d'écriture (WT, TB), sur des conducteurs collecteurs communs (RB et WB ou R/WB), qui sont en outre reliés directement aux circuits de commutation d'entrée et de sortie de données (D1 et D0 ou DIO) communs à toutes les sous-matrices (SA 1 à SA N), et en ce que les transistors de lecture servent à la fois d'amplificateurs et d'éléments de découplage pour les conducteurs de bits et les conducteurs collecteurs.

2. Mémoire suivant la revendication 1, caractérisée en ce que les paires de conducteurs de bits (B0, B1) sont reliées par l'intermédiaire de transistors d'écriture (WT) aux conducteurs collecteurs d'écriture de données communs (WB).

3. Mémoire suivant les revendications 1 et 2, caractérisée en ce que les sous-matrices (SA 1 à SA N) sont reliées par l'intermédiaire de conducteurs de commande (YE et SEL 1 à N) aux circuits de commutation de décodage (DSA) pour leur sélection.

4. Mémoire suivant les revendications 1 à 3, caractérisée en ce que les paires de conducteurs de bits (B0 et B1) de même valeur (par exemple, bit 1) de chaque sous-matrice (SA 1 à SA N) sont reliées par des transistors (TB 0, TB 1) à un conducteur collecteur (RB/WB) combiné pour la lecture et l'écriture, lesquels sont eux-mêmes reliés à des circuits d'entrée et de sortie de données (DIO 1 et 2) pour la lecture et l'écriture.

5. Mémoire suivant la revendication 1, caractérisée en ce que des transistors d'écriture (WT) d'une sous-matrice (par exemple SA 1) sont alimentés par l'intermédiaire d'une source de courant commune (IWG) et commandés par l'intermédiaire d'un conducteur de commande commun (WRS) qui est relié directement au décodeur (DSA) pour les sous-matrices (SA 1 à SA N), tandis que les transistors de lecture (TB 0 ou TB 1) sont reliés à l'intérieur d'une sous-matrice (SA 1 à SA N) par l'intermédiaire d'un autre conducteur de commande commun (RS), au décodeur (DSA) pour les sous-matrices.

FIG.1

FIG. 2

FIG. 4

FIG.3